# EUROPEAN PATENT SPECIFICATION

(11) **EP 1 881 604 B1**
(45) Date of publication and mention of the grant of the patent: **30.12.2009**
(21) Application number: 07112476.2
(22) Date of filing: 13.07.2007
(51) Int. Cl.: H03H 7/38

(54) **Automatic termination circuit**
Automatische Abschlussschaltung
Circuit de terminaison automatique

(30) Priority: 18.07.2006 US 458320
(43) Date of publication of application: 23.01.2008
(73) Proprietor: Honeywell International Inc., Morristown NJ 07960 (US)
(72) Inventor: Peterson, James F, Clearwater, FL 33759 (US)
(74) Representative: Haley, Stephen

(56) References cited:
- WO-A-98/13766
- WO-A-02/087198
- WO-A-2006/054245
- US-A- 5 347 538

## Description

Data transfer rates used in new electronic components have been increasing and are expected to increase further. Signal rise and fall times are now less than one nanosecond (1 x 10⁻⁹), and the expectation is that these times will continue to decrease. To accommodate these expectations, electronic component designs often use a "point-to-point" topology in which each signal driver in the electronic component has a single corresponding load point (for example, a printed circuit board (PCB) trace).

Because of these sub-nanosecond signal edges, every PCB trace can effectively become a transmission line. It is not uncommon that each trace (that is, each corresponding load point) requires termination in order to prevent noise problems such as signal reflection, ringing, and signal overshoot or undershoot. In a point-to-point topology, a series termination at the source (driver) is an ideal way to terminate the circuit. The impedance value of a terminating resistor is selected depending on the associated electronic component's buffer technology, signal driver strength, and PCB trace impedance levels. The signal's driver strength can be represented by a source impedance or source resistance. In particular, signal reflection occurs when the impedance of the signal driver does not effectively match an impedance level of the PCB trace connected to the signal driver. In order to limit signal reflection, these "source" terminations are typically placed as close as possible to a signal driver within the electronic component.

Typically, electronic component designers use a limited number of approaches to eliminate signal reflection. In one approach that makes use of simulation studies and circuit models, the impedance matching calculations are performed in early stages of the component design. Evaluations of preliminary designs are conducted in a laboratory setting by manual adjustments, often with experimental circuitry that attempts to simulate actual operating conditions. Configuring certain components, such as an application-specific integrated circuit (ASIC) or a field-programmable gate array (FPGA), typically occurs during fabrication (for ASICs), startup, or reset events (for FPGAs) and is typically not adjustable during component operation. Further, adding termination circuitry is not always required, depending on the length of the transmission line (that is, PCB trace). When termination circuitry is included where it is not required, the termination circuitry may create an unnecessary burden on the operation of the electronic component.

US-A-5347538 discloses a transceiver for transmission over serial by-directional links and having a by-directional amplifier.

These and other features, aspects, and advantages will become better understood with regard to the following description, appended claims, and accompanying drawings were:
FIG. 1 is a block diagram of an embodiment of an electronic circuit incorporating at least one automatic termination circuit;
FIG. 2 is a block diagram of an embodiment of an automatic termination circuit;
FIG. 3 is a flow diagram illustrating a method of an embodiment for configuring at least one termination circuit in an electronic device; and
FIG. 4 is a block diagram of an alternate embodiment of an electronic circuit incorporating at least one automatic termination circuit.

Like reference numbers and designations in the various drawings indicate like element.

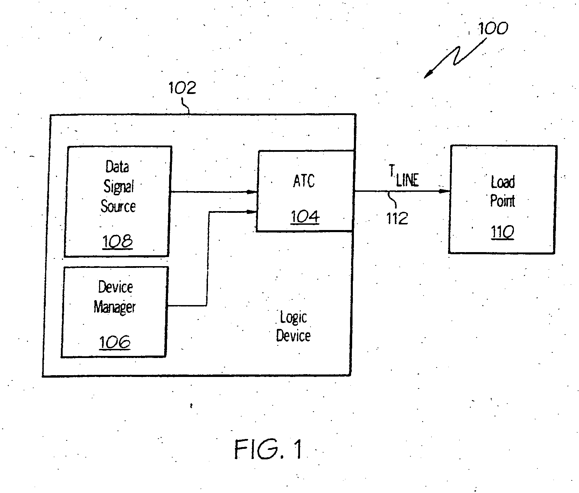

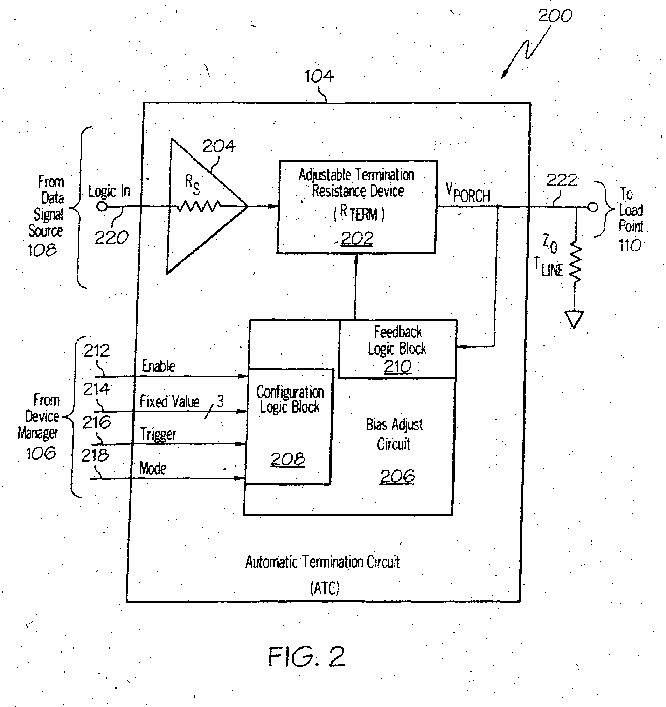

FIG. 1 is a block diagram of an embodiment of an electronic circuit 100, incorporating at least one automatic termination circuit. The electronic circuit 100 comprises a logic device 102 and a load point 110. The logic device 102 further comprises a data signal source 108, a device manager 106, and an automatic termination circuit (ATC) 104. Examples of the logic device 102 include, without limitation, any programmable logic device such as an ASIC, an FPGA, a field-programmable object array (FPOA). The device manager 106 resides within the logic device 102 and is responsible for the configuration and control of logic device 102. The data signal source 108 resides within the logic device 102 and maintains at least one source of data. The ATC 104 is in communication with the device manager 106 and the data signal source 108. The ATC 104 is described further in connection with FIG. 2.

The ATC 104 is coupled to a load point 110 by a transmission line (T-LINE) 112. In the example embodiment of FIG. 1, the load point 110 receives one data signal on the T_{LINE} 112 from the logic device 102. The load point 110 comprises at least one common logic receiver point for the logic device 102. In alternate embodiments, the load point 110 receives any type of electronic signal data from a plurality of electronic devices, including any additional logic devices 102, mounted on a printed wiring assembly board (PWBA; not shown).

In operation, the device manager 106 determines when and how to configure the ATC 104 for limiting signal reflections while the logic device 102 is in use. Depending on a trace length and/or impedance of the T_{LINE} 112, several options are available. Operating the ATC 104 in an "automatic" or "auto" mode ensures that an optimum terminal resistance value is present at an output of the ATC 104 at all times. The optimum terminal resistance substantially matches a load impedance of the T_{LINE} 112. Additional options include disabling the ATC 104 if the trace length of the T_{LINE} 112 does not introduce a significant amount of signal reflection. Operating in a "command" mode sets the ATC 104 to one or more fixed terminal resistance values. The option of operating in "command" mode affords the opportunity to evaluate termination effectiveness and quality of the T _{LINE} 112.

FIG. 2 is a block diagram 200 of an embodiment of the ATC 104 of FIG. 1. ATC 104 comprises at least one output buffer 204. an adjustable termination resistance device 202 having an associated termination resistance R_{TERM}, and a bias adjust circuit 206. The at least one output buffer 204 acts as a signal driver and has as an input to receive logical ones and zeros provided on a signal input line 220. In the example embodiment of FIG. 2, the at least one output buffer 204 includes or has a drive strength that is accurately represented with a source resistance R_{S}. R_{S} defines the drive strength provided to an input terminal of the ATC 104 from the data signal source 108 of FIG. 1. The bias adjust circuit 206 includes a configuration logic block 208 and a feedback logic block 210. In the example embodiment of FIG. 2, the adjustable termination resistance device 202 comprises a field effect transistor (FET). A source terminal of the FET used to implement the adjustable termination resistance device 202 is coupled to the at least one output buffer 204. A drain (output) terminal of such FET is coupled to a transmission line (T_{LINE}) 222. As illustrated in FIG. 2 , Z₀ represents a resistor to ground impedance of the T_{LINE} 222. A gate terminal of the FET (used to implement the adjustable termination resistance device 202) is connected to the feedback logic 210. A feedback signal line is coupled between the output terminal of the adjustable termination resistance device 202 and the feedback logic block 210 in order to provide feedback to the bias adjust circuit 206. In the particular embodiment shown in FIG. 2, such feedback is based on at least the output voltage at an output terminal of the adjustable termination resistance device 202 (that is, V_{PORCH} as described below). Configuration logic block 208 receives several input signals from the device manager 106 of FIG. 1, namely an enable input signal 212, a fixed value input signal 214, a trigger input signal 216, and a mode input signal 218.

In operation, a logical input signal (Logic IN) is supplied to the at least one output buffer 204 on the signal input line 220. The bias adjust circuit 206 receives at least one operating mode instruction from the device manager 106 on the mode input signal 218. In one implementation, the bias adjust circuit 206 enters either an "auto" mode or a "command" mode depending on the at least one operating mode instruction received from the device manager 106. In the auto mode, trigger input 216 identifies when to evaluate V_{PORCH} and is set by the device manager 102. V_{PORCH} signifies a voltage level present at the output terminal of the adjustable termination resistance device 202. When both enable input 212 and trigger input 216 each provide an active input signal, V_{PORCH} is evaluated as a feedback signal to the feedback logic block 210. Based on the value of V_{PORCH}, the feedback logic block 210 supplies a biased voltage value to the adjustable termination resistance device 202. In one implementation, the feedback logic block 210 comprises a feedback amplifier. The biased voltage value is applied to the gate terminal of the adjustable termination resistance device 202. The adjustable termination resistance device 202 automatically adjusts a source to drain resistance (R_{SD}) across the source and the drain terminals of the adjustable termination resistance device 202. When the trigger input signal 216 is inactive, the adjustable termination resistance device 202 retains a previously adjusted R_{TERM} value.

The bias adjust circuit 206 regulates an amount by which the R_{TERM} value of the adjustable termination resistance device 202 is adjusted. In one implementation, the bias adjust circuit 206 regulates R_{TERM} until V_{PORCH} is substantially half of the Logic IN signal on the signal input line 220. At this point, an impedance level at the output terminal of the ATC 104 (that is, R_{TERM} + R_{S}) substantially matches the load point impedance Z₀ of the T_{LINE} 222, and the T_{LINE} 222 is considered ideally terminated (with respect to the load point 110 of FIG. 1). In situations where the adjustable termination resistance device 202 does not require any regulation (that is, where there is no detectable level of signal reflection present), the enable input signal 212 will be issued a disable (inactive) command from the device manager 106 of FIG. 1. When the enable input signal 212 is inactive, the configuration logic 208 sets R_{TERM} to a minimum value, and the ATC 104 is placed in a "non-terminated" state.

In the command mode, the device manager 106 issues at least one fixed value word on the fixed value input signal 214. The at least one fixed value word represents at least one fixed value for R_{TERM}. In one implementation, the configuration logic 208 instructs the feedback logic 210 to convert the at least one fixed value word to a corresponding biased voltage value for the gate terminal of the adjustable termination resistance device 202. The source to drain resistance across the source and drain terminals of the adjustable termination resistance device 202 automatically adjusts to substantially equal the at least one fixed value for R_{TERM}, In one implementation, the fixed value input signal 214 comprises at least three input lines. The at least three input lines provide at least eight possible combinations of fixed value words (that is, at least eight different options for fixed values of R_{TERM}).

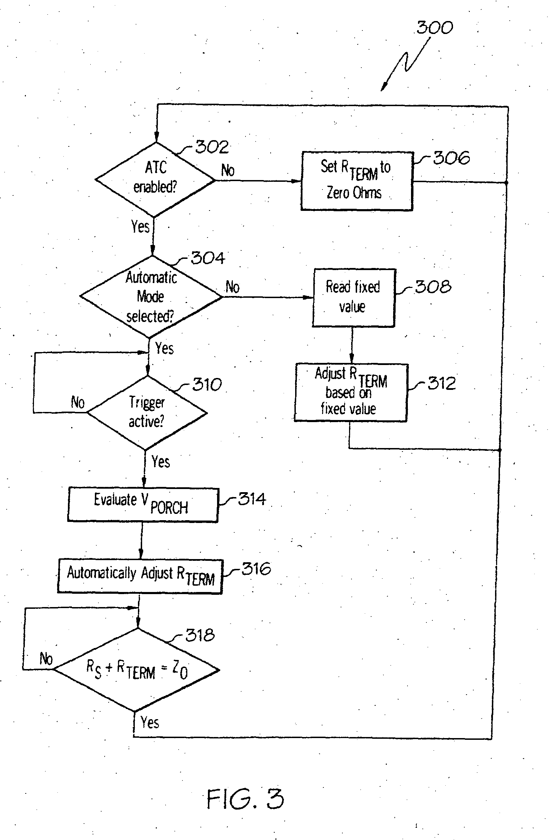

FIG. 3 is a flow diagram illustrating a method 300 for configuring at least one termination circuit in an electronic device. The particular embodiment of method 300 is described in connection with the electronic circuit 100 of FIG. 1 and the ATC 104 of FIG. 2 (though other embodiments are implemented in other ways). In one implementation of such an embodiment, at least a portion of the processing of the method 300 is performed by the bias adjust circuit 206. A primary function of the method 300 is to automatically adjust the value of R_{TERM} as instructed by the mode input signal 218.

In one implementation, the method 300 establishes a current state of the ATC 104 based on the enable input signal 212 (block 302). If the ATC 104 is not enabled, the adjustable termination resistance device 202 is placed in a Bypass Mode at block 306. In one implementation, the FET of the adjustable termination resistance device 202 is fully turned on, which makes R_{TERM} substantially equal to zero ohms. If the ATC 104 is enabled, then the method 300 determines if the ATC 104 has an Automatic Mode enabled (block 304). If the Automatic Mode is enabled, the method 300 waits for a trigger event (block 310). If the trigger input signal 216 is active and enabled, the method 300 continues at block 314. V_{PORCH} (or some value indicative thereof) is evaluated by the bias adjust circuit 206 at block 314. While the trigger input signal 216 is active, the adjustable termination resistance device 202 automatically adjusts R_{TERM} at block 316 until V_{PORCH} is substantially half of the Logic IN signal present on the signal input line 220. In one implementation, the bias adjust circuit 206 automatically adjusts R_{TERM} until the drive strength impedance R_{S} + R_{TERM} substantially match the load point impedance Z₀ of the T_{LINE} 222. If the Automatic Mode is enabled but the trigger input signal 216 is not active, R_{TERM} retains its previous value. If the Automatic mode was not selected at block 304, a fixed value is read from the fixed value input signal 214 at block 308. At block 312, the ATC 104 is in Command Mode, and the bias adjust circuit 206 adjusts the R_{TERM} value of the adjustable termination resistance device 202 based on the fixed value read from the fixed value input signal 214.

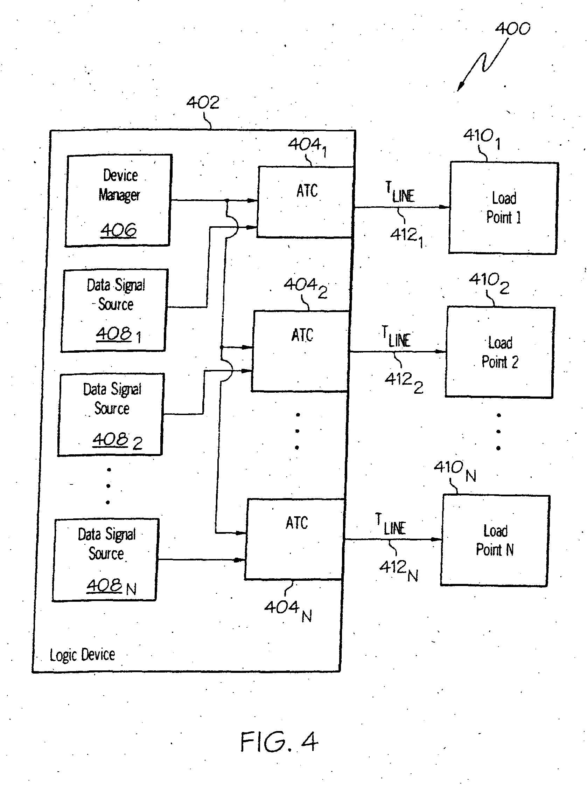

As noted above, FIGS. 1 through 3 illustrate one embodiment of the electronic circuit 100, the ATC 104, and the at least one associated method 300, respectively. It is to be understood that other embodiments are implemented in other ways. Indeed, the ATC 104 illustrated in FIGS. 1 through 3 is adaptable for a wide variety of applications. For example, FIG. 4 is a block diagram of an alternative embodiment of the electronic circuit 100, an electronic circuit 400. The embodiment of the electronic circuit 400 shown in FIG. 4 includes three or more ATCs 404, three or more load points 410, and three or more T_{LINES} 412. The three ATCs 404 are individually referenced in FIG. 4 as ATC 404₁, 404₂, and 404_{N}, respectively. The three load points 410 are individually referenced in FIG. 4 as load point 410₁ (load point 1), 410₂ (load point 2), and 410_{N} (load point N), respectively. The three T_{LINES} 412 are individually referenced in FIG. 4 as T_{LINE} 412₁, T_{LINE} 412₂, and T_{LINE} 410_{N}, respectively. It is understood that the electronic circuit 400 is capable of accommodating any appropriate number of the ATCs 404, the load points 410, and the T_{LINES} 412 (for example, at least three ATCs 404, at least three load points 410, and at least three T_{LINES} 412) in a single electronic circuit 400.

In the embodiment shown in FIG. 4, electronic circuit 400 further comprises a logic device 402. The logic device 402 includes a device manager 406 and three or more data signal sources 408₁ to 408_{N}. Similar to the electronic circuit 100, the device manager 406 is responsible for the configuration and control of logic device 402. Each of the three or more data signal sources 408₁ to 408_{N} maintain at least one source of data for each of the ATCs 104₁ to 104_{N}. Each of the ATCs 104₁ to 104_{N} are coupled to each of the load points 410₁ to 410_{N} by a respective T_{LINE} 412₁ to T_{LlNE}412_{N}.

This description has been presented for purposes of illustration, and is not intended to be exhaustive or limited to the form (or forms) disclosed. Variations and modifications may occur, which fall within the scope of the embodiments described above, as set forth in the following claims.

## Claims

1. A device (102) comprising:
a data signal source (108);
an automatic termination circuit (104) connected to the data signal source
an output terminal (202) to connect an output of the automatic termination circuit to a transmission line (112);
a load point (110) coupled to the transmission line;
wherein the automatic termination circuit comprises an adjustable termination resistance device having an associated termination resistance; and
wherein the automatic termination circuit is operable to automatically adjust the termination resistance associated with the adjustable termination resistance device while the load point is coupled to the transmission line by using feedback;
wherein the feedback is based on at least an output voltage at the output terminal of a signal sent from the automatic termination circuit on the transmission line to the load.

2. The device (102) of claim 1, further comprising a device manager (106) that is communicatively coupled to the automatic termination circuit, wherein the device manager is operable to control the operation of the automatic termination circuit.

3. The device (102) of claim 1, wherein the automatic termination circuit (104) supports a plurality of operational modes, wherein in one of the plurality of operational modes the automatic termination circuit automatically adjusts the termination resistance associated with the adjustable termination resistance device using the feedback.

4. The device (102) of claim 3, wherein in one of the plurality of operational modes the automatic termination circuit (104) sets the termination resistance to a fixed resistance value.

5. The device (102) of claim 3, further comprising a plurality of automatic termination circuits (404-1, ..., 404-N) and a plurality of output terminals to connect a respective output of a respective one of the plurality of automatic termination circuits to a respective one of a plurality of transmission lines (412-1, ..., 412-N);
wherein each of the plurality of automatic termination circuits comprises a respective adjustable termination resistance device having a respective associated termination resistance and wherein a respective output voltage is present at the respective output terminal; and
wherein each of the plurality of automatic termination circuits is operable to automatically adjust the respective termination resistance associated with the respective adjustable termination resistance device for that automatic termination circuit using respective feedback associated with that automatic termination circuit, wherein the respective feedback is based on at least the respective output voltage for that automatic termination circuit.

6. The device (102) of claim 1, wherein the automatic termination circuit further comprises an output buffer (204) having an associated drive strength resistance; and
wherein the automatic termination circuit is operable to automatically adjust the termination resistance associated with the adjustable termination resistance device so that a sum of the drive strength resistance and the termination resistance substantially match a load point impedance of the transmission line.

7. The device (102) of claim 1, wherein the adjustable termination resistance device comprises a field effect transistor (202), wherein the termination resistance associated with the adjustable termination resistance device comprises a resistance between a source and a drain of the field effect transistor, wherein the termination resistance is adjusted by adjusting a gate voltage applied to a gate of the field effect transistor.

8. The device (102) of claim 1, wherein the automatic termination circuit (104) further comprises a bias adjust circuit (206) to automatically adjust the termination resistance associated with the adjustable termination resistance device;
wherein the bias adjust circuit measures an output voltage during a porch in the signal sent from the automatic termination circuit to the load point.

9. The device (102) of claim 1, wherein the automatic termination circuit (104) automatically adjusts the termination resistance using the feedback when a trigger signal is asserted.

## Patentansprüche

1. Anordnung (102), umfassend:
eine Datensignalquelle (108);
eine mit der Datensignalquelle verbundene automatische Abschlussschaltung (104);
einen Ausgangsanschluss (202) zum Verbinden eines Ausgangs der automatischen Abschlussschaltung mit einer Übertragungsleitung (112);
einen mit der Übertragungsleitung gekoppelten Lastpunkt (110);
wobei die automatische Abschlussschaltung eine einstellbare Abschlusswiderstandsanordnung mit einem assoziierten Abschlusswiderstand umfasst; und
wobei die automatische Abschlussschaltung betreibbar ist, den mit der einstellbaren Abschlusswiderstandsanordnung assoziierten Abschlusswiderstand automatisch einzustellen, während der Lastpunkt mit der Übertragungsleitung gekoppelt wird, indem Rückkopplung verwendet wird;
wobei die Rückkopplung auf mindestens einer Ausgangsspannung an dem Ausgangsanschluss eines von der automatischen Abschlussschaltung auf der Übertragungsleitung zu der Last gesendeten Signals basiert.

2. Anordnung (102) nach Anspruch 1, ferner mit einem Anordnungsmanager (106), der kommunikativ mit der automatischen Abschlussschaltung gekoppelt ist, wobei der Anordnungsmanager betreibbar ist, um den Betrieb der automatischen Abschlussschaltung zu steuern.

3. Anordnung (102) nach Anspruch 1, wobei die automatische Abschlussschaltung (104) mehrere Betriebsarten unterstützt, wobei in einer der mehreren Betriebsarten die automatische Abschlussschaltung automatisch unter Verwendung der Rückkopplung den mit der einstellbaren Abschlusswiderstandsanordnung assoziierten Abschlusswiderstand einstellt.

4. Anordnung (102) nach Anspruch 3, wobei in einer der mehreren Betriebsarten die automatische Abschlussschaltung (104) den Abschlusswiderstand auf einen festen Widerstandswert setzt.

5. Anordnung (102) nach Anspruch 3, ferner mit mehreren automatischen Abschlussschaltungen (404-1, ..., 404-N) und mehreren Ausgangsanschlüssen zum Verbinden eines jeweiligen Ausgangs einer jeweiligen der mehreren automatischen Abschlussschaltungen mit einer jeweiligen von mehreren Übertragungsleitungen (412-1, ..., 412-N);
wobei jede der mehreren automatischen Abschlussschaltungen eine jeweilige einstellbare Abschlusswiderstandsanordnung mit einem jeweiligen assoziierten Abschlusswiderstand umfasst und wobei eine jeweilige Ausgangsspannung an dem jeweiligen Ausgangsanschluss vorliegt; und
wobei jede der mehreren automatischen Abschlussschaltungen betreibbar ist, um den mit der jeweiligen einstellbaren Abschlusswiderstandsanordnung für diese automatische Abschlussschaltung assoziierten jeweiligen Abschlusswiderstand automatisch unter Verwendung jeweiliger mit dieser automatischen Abschlussschaltung assoziierter Rückkopplung einzustellen, wobei die jeweilige Rückkopplung auf mindestens der jeweiligen Ausgangsspannung für diese automatische Abschlussschaltung basiert.

6. Anordnung (102) nach Anspruch 1, wobei die automatische Abschlussschaltung ferner einen Ausgangspuffer (204) umfasst, der einen assoziierten Ansteuerstärkewiderstand aufweist; und
wobei die automatische Abschlussschaltung betreibbar ist, um den mit der einstellbaren Abschlusswiderstandsanordnung assoziierten Abschlusswiderstand so automatisch einzustellen, dass die Summe des Ansteuerstärkewiderstands und des Abschlusswiderstands im Wesentlichen mit einer Lastpunktimpedanz der Übertragungsleitung übereinstimmt.

7. Anordnung (102) nach Anspruch 1, wobei die einstellbare Abschlusswiderstandsanordnung einen Feldeffekttransistor (202) umfasst, wobei der mit der einstellbaren Abschlusswiderstandsanordnung assoziierte Abschlusswiderstand einen Widerstand zwischen einem Source- und einem Drainanschluss des Feldeffekttransistors umfasst, wobei der Abschlusswiderstand durch Einstellen einer an ein Gate des Feldeffekttransistors angelegten Gatespannung eingestellt wird.

8. Anordnung (102) nach Anspruch 1, wobei die automatische Abschlussschaltung (104) ferner eine Vorspannungseinstellschaltung (206) zum automatischen Einstellen des mit der einstellbaren Abschlusswiderstandsanordnung assoziierten Abschlusswiderstands umfasst;
wobei die Vorspannungseinstellschaltung eine Ausgangsspannung während einer Schulter in dem von der automatischen Abschlussschaltung zu dem Lastpunkt gesendeten Signal misst.

9. Anordnung (102) nach Anspruch 1, wobei die automatische Abschlussschaltung (104) den Abschlusswiderstand automatisch unter Verwendung der Rückkopplung einstellt, wenn ein Triggersignal gesetzt wird.

## Revendications

1. Dispositif (102) comprenant :
une source (108) de signaux de données ;
un circuit de terminaison automatique (104) lequel est connecté à la source de signaux de données ;
une borne de sortie (202) pour connecter une sortie du circuit de terminaison automatique à une ligne de transmission (112) ;
un point de charge (110) couplé à la ligne de transmission ;
cas dans lequel le circuit de terminaison automatique comprend un dispositif à résistance de terminaison réglable ayant une résistance de terminaison associée ; et
cas dans lequel le circuit de terminaison automatique est opérable pour régler automatiquement la résistance de terminaison associée au dispositif à résistance de terminaison réglable pendant que le point de charge est couplé à la ligne de transmission grâce à l'utilisation de la rétroaction ;
cas dans lequel la rétroaction est fondée sur au moins une tension de sortie, au niveau de la borne de sortie, d'un signal envoyé à partir du circuit de terminaison automatique sur la ligne de transmission vers la charge.

2. Dispositif (102) selon la revendication 1, comprenant en outre un gestionnaire (106) de dispositif lequel est couplé de façon communicante au circuit de terminaison automatique, cas dans lequel le gestionnaire de dispositif est opérable de manière à piloter le fonctionnement du circuit de terminaison automatique.

3. Dispositif (102) selon la revendication 1, le circuit de terminaison automatique (104) supportant une pluralité de modes opérationnels, cas dans lequel dans l'un des modes de la pluralité de modes opérationnels, le circuit de terminaison automatique règle automatiquement la résistance de terminaison associée au dispositif à résistance de terminaison réglable grâce à l'utilisation de la rétroaction.

4. Dispositif (102) selon la revendication 3, dans l'un des modes de la pluralité de modes opérationnels le circuit de terminaison automatique (104) définissant la résistance de terminaison à une valeur de résistance fixe.

5. Dispositif (102) selon la revendication 3, comprenant en outre une pluralité de circuits de terminaison automatique (404-1, ..., 404-N) et une pluralité de bornes de sortie afin de connecter une sortie respective d'un circuit respectif de la pluralité de circuits de terminaison automatique à une ligne respective d'une pluralité de lignes de transmission (412-1, ..., 412-N) ;
cas dans lequel chaque circuit de la pluralité de circuits de terminaison automatique comprend un dispositif respectif à résistance de terminaison réglable ayant une résistance respective de terminaison associée et cas dans lequel une tension de sortie respective est présente au niveau de la borne de sortie respective ; et
cas dans lequel chaque circuit de la pluralité de circuits de terminaison automatique est opérable pour régler automatiquement la résistance de terminaison respective associée au dispositif respectif à résistance de terminaison réglable pour ce circuit de terminaison automatique grâce à l'utilisation de la rétroaction respective associée à ce circuit de terminaison automatique, cas dans lequel la rétroaction respective est fondée sur au moins la tension de sortie respective pour ce circuit de terminaison automatique.

6. Dispositif (102) selon la revendication 1, le circuit de terminaison automatique comprenant en outre un tampon (204) de sortie ayant une résistance d'intensité du signal d'attaque associée ; et
cas dans lequel le circuit de terminaison automatique est opérable pour régler automatiquement la résistance de terminaison associée au dispositif à résistance de terminaison réglable de sorte qu'une somme de la résistance d'intensité du signal d'attaque et de la résistance de terminaison soit sensiblement assortie à une impédance du point de charge de la ligne de transmission.

7. Dispositif (102) selon la revendication 1, le dispositif à résistance de terminaison réglable comprenant un transistor à effet de champ (202), cas dans lequel la résistance de terminaison associée au dispositif à résistance de terminaison réglable comporte une résistance entre une source et un drain du transistor à effet de champ, cas dans lequel la résistance de terminaison est réglée grâce au réglage d'une tension de grille injectée à une grille du transistor à effet de champ.

8. Dispositif (102) selon la revendication 1, le circuit de terminaison automatique (104) comprenant en outre un circuit de réglage de polarisation (206) afin de régler automatiquement la résistance de terminaison associée au dispositif à résistance de terminaison réglable ;
cas dans lequel le circuit de réglage de polarisation mesure une tension de sortie pendant un palier du signal envoyé à partir du circuit de terminaison automatique vers le point de charge.

9. Dispositif (102) selon la revendication 1, le circuit de terminaison automatique (104) réglant automatiquement la résistance de terminaison grâce à l'utilisation de la rétroaction au moment de l'excitation d'un signal de déclenchement.
